# EUROPÄISCHE PATENTANMELDUNG

(11) **EP 4 273 911 A1**
(43) Veröffentlichungstag der Anmeldung: **08.11.2023**
(21) Anmeldenummer: 23171299.3
(22) Anmeldetag: 03.05.2023
(51) Int. Cl.: H01L 21/677, H01L 21/683, H01L 21/687

(54) **HALTEVORRICHTUNG UND VERFAHREN ZUM HALTEN UND/ODER TRANSPORTIEREN VON WERKSTÜCKEN UND/ODER BAUTEILEN, OPTIONAL MIT WERKZEUGFREI AUSWECHSELBAREN SAUGERELEMENTEN**

(30) Priorität: 03.05.2022 DE 102022110882
(71) Anmelder: Werner Lieb GmbH, 96472 Rödental (DE)
(72) Erfinder: Linke, Christian, 96472 Rödental (DE)
(74) Vertreter: Spachmann, Holger

(57) **Zusammenfassung**

Die Erfindung betrifft eine Haltevorrichtung (3), zum Halten und/oder Transportieren von Werkstücken (2) und/oder Bauteilen, insbesondere beispielsweise Wafer der Halbleitertechnik.

Es wird vorgeschlagen, dass zum Halten und/oder Transportieren der Werkstücke (2) und/oder Bauteile eine Vakuumeinrichtung (10) umfasst ist, wobei die Haltevorrichtung (3) zweiteilig ausgebildet ist, wobei zwei im Wesentlichen parallel zueinander angeordnete, insbesondere blechförmige, Teilelemente (4,5) umfasst sind, wobei zur Bildung der Vakuumeinrichtung (10) Zuleitungen (11) mit endseitigen Ansaugöffnungen (12) vorgesehen sind, sodass ein Vakuum zwischen der Haltevorrichtung (3) und dem Werkstück (2) und/oder Bauteil ausbildbar ist, wobei die Zuleitungen (11) durch einen Prägevorgang in zumindest einem der Teilelemente (4, 5) ausgebildet sind.

Optional sind die geprägten Zuleitungen (11) und Ansaugöffnungen (12) derart mit Prägestrukturen ausgebildet, dass Saugerelemente (16) werkzeugfrei in den Ansaugöffnungen (12) einbringbar sind.

Daneben betrifft die Erfindung ein Verfahren zum Halten und/oder Transportieren von Werkstücken (2) und/oder Bauteilen, insbesondere der Halbleitertechnik, umfassend insbesondere eine vorgeschlagene Haltevorrichtung (3).

## Beschreibung

Die Erfindung betrifft eine Haltevorrichtung, zum Halten und/oder Transportieren von Werkstücken und/oder Bauteilen, insbesondere der Halbleitertechnik. Des Weiteren betrifft die Erfindung ein Verfahren zum Halten und/oder Transportieren von Werkstücken und/oder Bauteilen, insbesondere der Halbleitertechnik

### STAND DER TECHNIK

Aus dem Stand der Technik sind Vorrichtungen zum Ausrichten von Werkstücken und/oder Bauteilen, insbesondere der Halbleitertechnik, bekannt. Diese sollen ein lagegenaues und ausgerichtetes Ablegen eines Werkstücks, eines Bauteils, eines Werkstückträgers oder ähnliches erzielen. Dieser kann auch als Wafer bezeichnet werden.

So zeigt die EP 3 790 041 A1 ein optisches Alignment-System für Wafer mit Notches, wobei eine maximale Beschleunigung und eine maximale Drehzahl des Chuckantriebs größer als eine maximale Scangeschwindigkeit eines optischen Abtastsensor zur Detektion des Notches ist. Es wird dabei wohl angenommen, dass der optische Abtastsensor vor Erreichen der maximalen Drehgeschwindigkeit bereits in der Lage ist, einen Notch zu erkennen. Dies soll dazu dienen, die Ausrichtgeschwindigkeit zu erhöhen.

Aus der EP 1 045 430 A2 ist ein Wafer Alignment-System bekannt, das mithilfe eines Gelenksroboters einen Wafer in ein Notch-Erkennungssystem einlegt. Zur Bestimmung des Wafer-Mittelpunkts für die Ablage auf den Chuck wird eine numerische Verarbeitung der CCD Daten des optischen Abtastsensors genutzt.

In derartigen Vorrichtungen werden Haltevorrichtungen bzw. Endeffektoren eingesetzt, um die Bauteile oder Werkstücke zu transportieren, aufzunehmen und/oder zu halten.

Dabei sollten ein sicherer Halt und eine sichere Aufnahme der Bauteile oder Werkstücke gewährleistet sein.

In der Regel werden die Werkstücke bzw. Bauteile, insbesondere Wafer und Mikroelektroniksubstrate in Kassetten gelagert, wobei diese mit vergleichsweise geringem Abstand zueinander innerhalb der Kassette übereinandergestapelt sind. Zur Handhabung der Werkstücke durch die Haltevorrichtung bzw. den Endeffektor ist es somit üblicherweise notwendig, mit der Haltevorrichtung in die entsprechenden Zwischenräume einzufahren, um das zu handhabende Werkstück zu greifen.

Hierbei ergibt sich regelmäßig die Problematik, dass der Abstand zwischen den Werkstücken zu gering ist, um während des Einfahrens einen Berührungskontakt der Haltevorrichtung bzw. des Endeffektors mit benachbarten Werkstücken und die damit einhergehende Gefahr einer etwaigen Beschädigung sicher auszuschließen. Dies ist insbesondere dann der Fall, wenn die Werkstücke nicht planar, sondern aufgrund entsprechender Bearbeitungsprozesse verbogen bzw. gewölbt sind.

Die DE 10 2018 100 855 A1 offenbart einen Endeffektor, der aus drei sandwichartig aufeinander angeordneten Lagen bzw. Schichten gebildet ist, die jeweils für sich alleine genommen nicht eigenstabil sind. Zur Erzeugung eines Vakuums zum Greifen der Werkstücke sind in die mittlere Schicht Vakuumkanäle eingebracht. Diese Vakuumkanäle sind durch einen Materialabtrag der mittleren Schicht erzeugt und dadurch in Form von Schlitzen ausgebildet. Die obere und untere Schicht sind in jenen Bereichen, die bei bestimmungsgemäßem Zusammenbau des Endeffektors im Bereich der Vakuumkanäle auf der mittleren Schicht aufliegen, geschlossen ausgebildet, sodass ein geschlossener Vakuumkreislauf erzeugt werden kann. Dieser Endeffektor weist aufgrund der Vielzahl einzelner Bauelemente jedoch eine hohe Komplexität hinsichtlich Herstellung und Montage auf. Gleichzeitig hat der Endeffektor den Nachteil, dass er einerseits aufgrund des vielschichtigen Aufbaus, insbesondere zwecks der zur Erzeugung der ausgefrästen oder ausgestanzten Vakuumkanäle notwendigen Materialdicke der mittleren Schicht, und andererseits zur Gewährleistung einer ausreichend hohen mechanischen Stabilität eine vergleichsweise hohe Gesamtdicke aufweist, da die einzelnen Schichten bzw. Lagen nicht eigenstabil sind.

Die US 2005 110 292 A1 offenbart einen Endeffektor mit einem Grundkörper, in welchem Vakuumkanäle in Form von Nuten eingefräst, also durch Materialabtrag erzeugt, sind. Zur Erzeugung eines geschlossenen Vakuumkreislaufs ist eine Abdichtplatte fluiddicht auf die Vakuumkanäle montiert. Auch dieser Endeffektor hat den Nachteil, dass er eine vergleichsweise hohe Gesamtdicke aufweist, da der Grundkörper eine gewisse Materialstärke benötigt, um die Vakuumkanäle einfräsen zu können. Zudem ist die hohe Gesamtdicke zur Gewährleistung einer ausreichend hohen mechanischen Stabilität erforderlich bzw. die mechanische Stabilität wird bei diesem Endeffektor durch die entsprechend hohe Materialstärke erreicht.

Die US 6 244 641 B1 offenbart ebenfalls einen Endeffektor mit einem relativ dicken Grundkörper, in welchen durch einen Materialabtrag Vakuumkanäle in Form von Nuten oder Schlitzen eingebracht sind. Zum Schließen der Vakuumkanäle wird eine Folie auf den Grundkörper fluiddicht aufgebracht. Auch dieser Endeffektor hat den Nachteil, dass er zur Gewährleistung der mechanischen Stabilität und Bereitstellung einer ausreichend hohen Materialstärke zum Einbringend er Vakuumkanäle eine vergleichsweise hohe Gesamtdicke aufweist.

Zusammenfassend weisen die bekannten Endeffektoren allesamt die Nachteile auf, dass sie zur Gewährleistung einer ausreichend hohen mechanischen Stabilität eine relativ hohe Gesamtdicke aufweisen, insbesondere aufgrund des zur Erzeugung der Vakuumkanäle notwendigen Materialabtrags vergleichsweise aufwändig herzustellen und aufgrund der Vielzahl an einzelnen Elementen relativ komplex zu montieren sind.

Aufgabe der Erfindung ist es daher, einen demgegenüber verbesserten Endeffektor bzw. eine verbesserte Haltevorrichtung vorzuschlagen, die besonders dünn und dennoch gleichzeitig mechanisch stabil ausbildbar ist, sodass beim Einfahren in die Kassette ein Berührungskontakt mir benachbarten Werkstücken zuverlässig vermeidbar ist und die Werkstücke dennoch sicher und zuverlässig handhabbar sind.

Diese Aufgabe wird durch eine Haltevorrichtung und ein Verfahren nach den unabhängigen Ansprüchen gelöst. Vorteilhafte Weiterentwicklungen der Erfindung sind Gegenstand der Unteransprüche und der Beschreibung.

### OFFENBARUNG DER ERFINDUNG

Gegenstand der Erfindung ist eine Haltevorrichtung zum Halten und/oder Transportieren von Werkstücken und/oder Bauteilen, insbesondere der Halbleitertechnik.

Es wird vorgeschlagen, dass zum Halten und/oder Transportieren der Werkstücke und/oder Bauteile eine Vakuumeinrichtung umfasst ist. Insbesondere ist die Vakuumeinrichtung integral in der Haltevorrichtung ausgebildet.

Das Vorsehen der erfindungsgemäßen Vakuumeinrichtung bietet den Vorteil, dass die Haltevorrichtung mit einer vergleichsweise geringen Bauhöhe ausbildbar ist, um beim Einfahren in eine Kassette zur Handhabung eines Werkstücks keine unmittelbar benachbarten Werkstücke zu berühren und dabei evtl. zu beschädigen. Die erfindungsgemäße Haltevorrichtung weist weiterhin trotz der geringen Dicke eine hohe Steifigkeit auf, sodass neben einer risikofreien Handhabung von Werkstücken auch eine ausreichend hohe mechanische Belastbarkeit der Haltevorrichtung sicher gewährleistbar ist.

Im Zusammenhang mit der vorliegenden Erfindung wird die Haltevorrichtung auch als Endeffektor bezeichnet.

Die Haltevorrichtung ist insbesondere zum Aufnehmen, Halten und Transportieren von scheibenartigen bzw. tellerartigen Werkstücken bzw. Bauteilen gedacht.

Bei dem Werkstück handelt es sich insbesondere um ein scheibenartiges Werkstück, insbesondere Halbleiterwafer oder Mikroelektroniksubstrat. Das Werkstück, im Halbleiterbreich "Wafer" genannt, wird insbesondere per Vakuum auf Position festgehalten. Unter Vakuum wird nachfolgend auch ein ausreichender Unterdruck verstanden, um eine ausreichende Haltekraft zum kraftschlüssigen Handling des Werkstücks bereitzustellen.

Die Haltevorrichtung bzw. der Endeffektor kann sich zur Handhabung von Werkstücken unterschiedlicher Größe eignen. Insbesondere können die Werkstücke kreisförmige bzw. scheibenförmig ausgebildet sein. Die Form des Werkstücks beschränkt sich dabei selbstverständlich nicht nur auf eine runde Form, sondern kann beispielsweise auch rechteckig oder quadratisch sein. Die Werkstücke können beispielsweise 6" oder 8" Wafer der Halbleiterindustrie sein. Grundsätzlich ist die vorliegende Haltevorrichtung bzw. der Endeffektor mindestens für Wafer der Größe 4" bis 12" verwendbar. Ebenso können im Wesentlichen plane, aber auch verbogene Bauteile aufgenommen werden. Insbesondere weisen die Bauteile eine Verbiegung von 0 mm bis zu 3 mm auf, abhängig von der Größe und Materials des Werkstückes

Bevorzugt wiegen die Werkstücke oder Bauteile maximal 1 kg . Jedoch sind auch leichtere oder schwerere Werkstücke bzw. Bauteile handhabbar.

Die Haltevorrichtung ist bevorzugt aus Edelstahl gefertigt. Alternativ kann die Haltevorrichtung jedoch auch aus anderen Werkstoffen wie beispielsweise Keramiken, (nichteisenhaltigen) Metallen, Kompositmaterialien, Carbonwerkstoff, sowie gesinterten oder gedruckten Werkstoffe gefertigt sein.

Die Oberfläche der Haltevorrichtung kann gebeizt, lackiert, pulverbeschichtet und/oder elektropoliert sein.

Die Haltevorrichtung kann bevorzugt in automatischen Anlagen, aber auch in einem Tischgerät verwendet werden. Beispielsweise kann die Vorrichtung insbesondere nicht autark betrieben werden und ist insbesondere für den Einbau in eine Anlage vorgesehen sein.

Gabelförmig bedeutet In einer bevorzugten Ausführungsform ist die Haltevorrichtung bzw. der Endeffektor zumindest bereichsweise gabelförmig ausgebildet und mit dem Werkstück und/oder Bauteil kontaktierbar. insbesondere, dass zwei Vorsprünge umfasst sind, die jeweils wie eine Zinke einer Gabel ausgebildet sind. Vorteilhafterweise ist die Haltevorrichtung dadurch mechanisch stabil bzw. steif insbesondere einer Querausdehnung gegenüber einer Längsachse der Haltevorrichtung ausgebildet und dennoch materialsparend und somit kostengünstig herstellbar. Zudem ermöglicht die Gabelform eine sichere Handhabung des Werkstücks

In einer bevorzugten Ausführungsform weist die Haltevorrichtung bzw. der Endeffektor einen mit dem Werkstück und/oder dem Bauteil kontaktierbaren Halteabschnitt zur Handhabung des Werkstücks und/oder Bauteil und einen, insbesondere einstückig mit dem Halteabschnitt ausgebildeten, Montageabschnitt zur Montage der Haltevorrichtung an einer Handhabungseinheit, insbesondere Roboter oder Roboterarm, auf. Die Haltevorrichtung ist dadurch besonders dünn und somit materialsparend ausbildbar und dennoch in der Lage, ihre bestimmungsgemäße Funktion uneingeschränkt zu erfüllen.

Eine Gesamtdicke der Haltevorrichtung im Bereich des Halteabschnitts kann zwischen 2 mm und 4 mm liegen. Bevorzugt beträgt die Gesamtdicke in diesem Bereich zwischen 2 mm bis 3 mm, insbesondere 2,4 mm.

Die Dicke im Bereich des Montageabschnitts kann größer als im Bereich des Halteabschnitts sein, insbesondere zwischen 3 mm und 6 mm, bevorzugt zwischen 3 mm und 4 mm, insbesondere 3,76 mm.

Erfindungsgemäß ist die Haltevorrichtung bzw. der Endeffektor zweiteilig ausgebildet, wobei zwei im Wesentlichen parallel zueinander angeordnete, insbesondere blechförmige, Teilelemente umfasst sind. Der Herstellungsprozess der Haltevorrichtung wird dadurch auf vorteilhafte Weise vereinfacht. Bevorzugt sind die beiden Teilelemente aus demselben Werkstoff, insbesondere Edelstahl, gefertigt, können alternativ jedoch auch aus unterschiedlichen Materialien bestehen

In einer bevorzugten Ausführungsform sind die Teilelemente im Wesentlichen deckungsgleich und/oder komplementär ausgebildet, wobei die Teilelemente zur Bildung der Haltevorrichtung bzw. des Endeffektors stoffschlüssig miteinander verbunden sind. Die Herstellung der Haltevorrichtung wird dadurch weiter vereinfacht und die Funktionalität verbessert. Die Teilelemente sind bevorzugt luftdicht miteinander verbunden. Insbesondere sind die Teilelemente miteinander verklebt oder verschweißt. Bevorzugt sind die Teilelemente unlösbar miteinander verbunden. Alternativ kann jedoch auch eine insbesondere lösbare kraft- und/oder formschlüssige Verbindung der Teilelemente miteinander vorgesehen sein, wodurch beispielsweise die Montage vereinfacht werden kann und insbesondere die Möglichkeit eines Austauschs von Teilen, beispielsweise im Rahmen von Wartungsprozessen oder im Falle von Beschädigungen, gegeben ist.

Erfindungsgemäß sind zur Bildung der Vakuumeinrichtung Zuleitungen mit endseitigen Ansaugöffnungen vorgesehen, sodass ein Vakuum zwischen der Haltevorrichtung und dem Werkstück ausbildbar ist. Die Vakuumeinrichtung ist dadurch vorteilhafterweise besonders platzsparend ausgebildet, sodass die Haltevorrichtung mit einer vergleichsweise geringen Dicke herstellbar ist.

Die Vakuumeinrichtung ist insofern im Wesentlichen aus den Zuleitungen und den Ansaugöffnungen gebildet. Zusätzlich ist bevorzugt ein mit der Haltevorrichtung bzw. dem Endeffektor koppelbarer Vakuumaktuator, beispielsweise Vakuumpumpe, zur Erzeugung des Vakuums, bzw. eines entsprechenden Unterdrucks umfasst, wobei der Vakuumaktuator dementsprechend der Haltevorrichtung bzw. den Zuleitungen zugeordnet ist.

Die Ansaugöffnungen sind bevorzugt in einem Endbereich der Zinken der Gabelform angeordnet, wobei vorzugsweise jede Zinke eine Ansaugöffnung aufweist. Zumindest eine weitere Ansaugöffnung kann an einer beliebigen Position im Bereich des Haltebereichs angeordnet sein. Bevorzugt sind mehr als zwei Ansaugöffnungen vorgesehen, insbesondere zwei bis sechs, bevorzugt drei Ansaugöffnungen. Die Ansaugöffnungen können derart ausgebildet sein, dass durch Vorsehen geeigneter Prägestrukturen ein werkzeugfreies Einklipsen eines Saugerelements oder einer Reibungskontaktauflagefläche ermöglicht wird. Insbesondere weisen die Ansaugöffnungen einen Prägerand auf, der ein Hintergreifen eines Klipsrandes des Saugerelements oder der Reibungskontaktauflagefläche ermöglicht.

Erfindungsgemäß sind die Zuleitungen zumindest in einem Teilelement ausgebildet. Vorteilhaft sind die Zuleitungen ausschließlich in einem der Teilelemente integriert, allerdings können Strukturen der Zuleitungen auch teilweise in beiden Teilelementen integriert sein. Erfindungsgemäß sind die Zuleitungen durch einen Prägevorgang in zumindest eines der Teilelemente hergestellt. Bevorzugt erfolgt der Prägevorgang in einem Teilelement, es können allerdings auch beide Teilelemente formkomplementär geprägt werden, um entsprechend großen Zuleitungsquerschnitte zu erreichen. Die Zuleitungen sind insofern als Vakuumkanäle in das entsprechende Teilelement eingeprägt und somit sickenartig ausgebildet. Durch diese integrale Ausbildung der Zuleitungen bzw. Vakuumeinrichtung in die Haltevorrichtung wird der Herstellungsprozess weiter vereinfacht und gleichzeitig eine besonders raumsparende Ausbildung von Haltevorrichtung und Vakuumeinrichtung ermöglicht.

Unter dem Prägevorgang bzw. der sickenartigen Ausbildung ist im Zusammenhang mit der vorliegenden Erfindung eine durch Kräfte erzeugte Verformung eines Grundkörpers, vorliegend des entsprechenden Teilelements, und somit explizit kein Materialabtrag, wie es insbesondere bei der Herstellung von Nuten, Schlitzen oder dergleichen der Fall ist, zu verstehen. Die geprägten bzw. sickenartigen Zuleitungen sind insofern keinesfalls mit Nuten, Schlitzen oder dergleichen gleichzusetzten.

Durch die sickenartigen Prägungen, insbesondere durch die Zuleitungen in zumindest einem Teilelement, kann das Teilelement ausgesteift werden. Somit kann das bzw. beide Teilelemente als nicht-eigenstabil ausgebildet werden, wobei die eingeprägten Sicken, die gleichzeitig die Vakuumzuleitungen ausbilden, und die erforderliche Stabilität bereitstellen. Weiterhin können weitere Sicken in zumindest ein, bzw. beide Teilelemente eingeprägt werden, um zusätzliche Versteifungen zu erreichen. Sind beide Teilelemente vakuumdicht miteinander, beispielsweise durch Schweißen, Kleben oder Löten, verbunden, so kann die komplette Haltevorrichtung durch die eingebrachten Sicken ausgesteift werden. Die Aussteifung durch die Prägungen der Zuleitungen, die als sickenartige Ausprägung der Vakuumzuleitungen innerhalb der Haltevorrichtung ausgeführt sind, bewirkt entscheidend eine hohe Tragkraft und Tragsteifigkeit der Haltevorrichtung, die durch die Doppelnutzung der Zuleitungen zur Unterdruck-/Vakuumzuführung und der mechanischen Versteifung der Haltevorrichtung bzw. des Endeffektors bewirkt wird.

Die Versteifung der Haltevorrichtung bzw. des Endeffektors, die zur Gewährleistung der im bestimmungsgemäßen Einsatz der Haltevorrichtung bzw. des Endeffektors benötigten mechanischen Stabilität notwendig ist, wird somit - im Gegensatz zu aus dem Stand der Technik bekannten Lösungen - erfindungsgemäß durch die Prägung bzw. sickenartige Ausbildung der Vakuumkanäle erreicht und nicht durch eine vergleichsweise hohe Dicke der Haltevorrichtung. Vielmehr ist bei der erfindungsgemäßen Lösung die Haltevorrichtung bzw. der Endeffektor derart dünn ausbildbar, dass ein Durchmesser der Vakuumkanäle größer ist, als die Dicke des zur Herstellung des Endeffektors verwendeten Materials, insbesondere Blechs.

Vorteilhafterweise ermöglicht die sickenartige Ausbildung daher eine besonders dünne Ausbildung des Endeffektors bei hoher mechanischer Stabilität.

Selbstverständlich können die Zuleitungen bzw. Vakuumkanäle optional nicht nur zur Leitung von Vakuum bzw. Unterdruck, sondern auch als Fluidkanäle für flüssige und gasförmige Fluide wie beispielsweise Luft, Stickstoff oder dergleichen genutzt werden. Dies kann beispielsweise zu Reinigungszwecken oder auch für andere Anwendungen außerhalb der zuvor erörterten Halbleiterfertigungsprozesse vorteilhaft sein.

In einer bevorzugten Ausführungsform sind in den Ansaugöffnungen Saugerelemente eingebracht. Die Saugerelemente ermöglichen auf vorteilhafte Weise eine sichere und beschädigungsfreie Handhabung der Werkstücke bzw. Bauteile.

Jeweils ein Saugerelement kann an einer Öffnung angeordnet werden. Die Saugerelemente können in die Öffnungen eingeklipst werden. Die Öffnungen können durch Bohrungen in dem Halteelement, insbesondere in einem Teilelement des Halteelements, ausgebildet sein. Insofern dienen die Öffnungen als mechanische Schnittstelle für die Saugerelemente

Die Saugerelemente weisen bevorzugt eine speziell auf das zu handhabende Werkstück abgestimmte Oberflächenbeschaffenheit und/oder -geometrie auf, um ein sicheres Anlegen an das insbesondere gebogene Werkstück zu gewährleisten. Die Saugerelemente sind bevorzugt aus einem Elastomer oder Kunststoff, insbesondere EPDM, gefertigt. Auch alternative Werkstoffe sind denkbar, solange sie konform mit etwaigen Richtlinien für erlaubte Materialen des jeweiligen Anwendungsfalls, insbesondere bei Substratkontakt in der Halbleiterindustrie, sind.

Die Saugerelemente können aus einem elektrisch leitfähigen Material bestehen, oder elektrisch leitfähige Partikel oder Elemente umfassen. Ebenso kann ein elektrisch leitfähiges Material enthalten sein, um insbesondere elektrostatische Aufladungen unterdrücken zu können.. Der Durchmesser kann zwischen 6 mm und 9 mm liegen, insbesondere zwischen 5 mm und 9 mm, bevorzugt 8,2 mm. Die Höhe des Saugerelements kann zwischen 2 mm und 3 mm, insbesondere 2,07 oder 2,57 mm betragen. Weitere Abmessungen sind ebenso denkbar. Ebenso sind weitere Geometrien des Saugerelements denkbar.

Bevorzugt sind die zuvor erwähnten Zuleitungen in das untere Teilelement eingeprägt, sodass die Zuleitung des Vakuums zu den Saugerelementen gewährleistet ist und/oder Raum für ein Einbringen der Saugerelemente gegeben ist. Insbesondere kann dadurch Raum für ein Einklipsen der Saugerelemente gegeben sein. Somit ist ein einfaches Auswechseln insbesondere bei Verschleiß oder Verlust einer Unterdruckfähigkeit ermöglicht.

In einer bevorzugten Ausführungsform sind die Saugerelemente als werkzeugfrei in den Ansaugöffnungen anordenbare, insbesondere in die Ansaugöffnungen einklipsbare, Saugpads ausgebildet, wobei die Saugpads eine umlaufende Einklipsnut aufweisen. Dadurch ist eine einfache und sichere Anordnung der Saugpads in den Ansaugöffnungen ermöglicht, wobei die Saugpads ohne Werkzeug bei Bedarf einfach herausgelöst werden können. Gleichzeitig ist vorteilhafterweise ein ungewolltes Herauslösen der Saugpads während der Handhabung der Werkstücke sicher vermieden.

Insbesondere ist ein Austausch der Saugerelemente ohne Demontage des Grundkörpers der Haltevorrichtung möglich.

Die Erfindung umfasst somit auch Saugerelemente zur Verwendung mit der vorstehend beschriebenen Haltevorrichtung. Die Saugerelemente sind insofern speziell zur Verwendung mit der Haltevorrichtung bzw. dem Endeffektor ausgebildet, jedoch separat handhabbar.

Gemäß einer alternativen Weiterbildung können die Saugerelemente durch Reibungskontaktauflageflächen ersetzt werden, die insbesondere im Wesentlichen analog zu den Saugpads in die Haltevorrichtung/den Endeffektor bzw. die entsprechenden Ansaugöffnungen eingebracht sind und durch das Vakuum bzw. den Unterdruck auf der Haltevorrichtung bzw. dem Endeffektor gehalten werden. Die Reibungskontaktauflageflächen sind derart ausgebildet, dass das Werkstück bzw. der Wafer nicht mittels Vakuums, sondern nur durch die Reibungskräfte, die zwischen der Reibungskontaktauflagefläche und dem Werkstück bestehen, gehalten wird. Herstellung und Kosteneffizienz der Haltevorrichtung können dadurch weiter vereinfacht bzw. verbessert werden.

Im Bereich eines Einsteckbereichs der Saugerelemente, insbesondere Saugpads oder der Reibungskontaktauflageflächen in einen endseitigen Ausgangsbereich der Zuleitungen können durch den Sickenprägevorgang ein Vertiefungsbereich, insbesondere ein kreisrunder Vertiefungsbereich in zumindest einem Teilelement, insbesondere in dem durch den Prägevorgang versteiften Teilelement, oder dem gegenüberliegenden Teilelement, oder in beiden Teilelemente eingebracht werden. Der Vertiefungsbereich eröffnet genügend Raum, dass ein Klipsrand der Saugerelemente bzw. Reibungskontaktauflageflächen die endseitige Öffnung der Zuleitungen im Teilelement hintergreifen kann.

Gegenstand der Erfindung ist weiterhin ein Verfahren zum Halten und/oder Transportieren von Werkstücken und/oder Bauteilen, insbesondere der Halbleitertechnik. Das Verfahren umfasst eine erfindungsgemäße Haltevorrichtung.

Gegenstand der Erfindung ist weiterhin ein Verfahren zur Herstellung einer, wie vorstehend beschriebenen, Haltevorrichtung bzw. eines solchen Endeffektors. Erfindungsgemäß ist vorgesehen, dass die Zuleitungen in Form einer Sicke durch einen Prägevorgang in zumindest einem der der Teilelemente eingeprägt werden. Es ergeben sich die im Vorfeld bereits genannten Vorteile.

### ZEICHNUNGEN

Weitere Vorteile ergeben sich aus der vorliegenden Zeichnungsbeschreibung. In den Zeichnungen sind Ausführungsbeispiele der Erfindung dargestellt. Die Zeichnungen, die Beschreibung und die Ansprüche enthalten zahlreiche Merkmale in Kombination. Der Fachmann wird die Merkmale zweckmäßigerweise auch einzeln betrachten und zu sinnvollen weiteren Kombinationen zusammenfassen.

Es zeigt:
- Fig. 1: eine perspektivische Darstellung einer Kassette mit darin gelagerten Werkstücken;
- Fig. 2: eine Explosionsdarstellung einer vorteilhaften Haltevorrichtung bzw. eines vorteilhaften Endeffektors zur Handhabung der in der Kassette gelagerten Werkstücke;
- Fig. 3A: eine Detailansicht eines ersten Teilelements der Haltevorrichtung;
- Fig. 3B: eine Detailansicht eines zweiten Teilelements der Haltevorrichtung;
- Fig. 4: eine Querschnittsdarstellung der Haltevorrichtung;
- Fig. 5: eine Detailansicht eines in der Haltevorrichtung angeordneten Saugerelements.

In den Figuren sind gleiche oder gleichartige Komponenten mit gleichen Bezeichnungen beziffert.

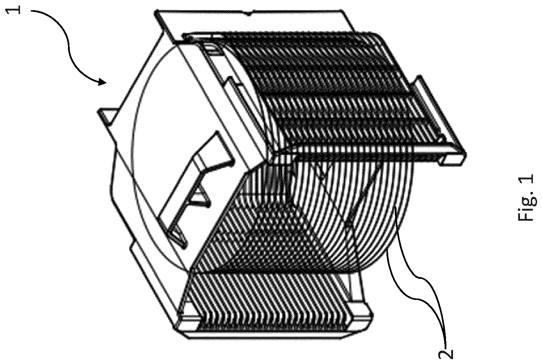

Figur 1 zeigt eine perspektivische Darstellung einer insbesondere im Bereich der Halbleitertechnik einsetzbaren bzw. eingesetzten Kassette 1. Die Kassette 1 dient dazu bzw. ist dazu ausgebildet, eine Vielzahl von Werkstücken 2 aufzunehmen und zumindest zwischenzulagern. Die Kassette 1 kann insofern als Lagereinrichtung für die Werkstücke 2 verstanden werden. Bei den Werkstücken 2 handelt es sich vorliegend um sogenannte Wafer, die in der Halbleitertechnik zur Herstellung von Chips und ähnlichen elektronischen Bauteilen verwendet werden.

Wie in Figur 1 gut zu erkennen ist, sind die Werkstücke 2 innerhalb der Kassette 1 übereinanderliegend angeordnet bzw. gestapelt. Um den durch die Kassette 1 bereitgestellten Lagerraum besonders effizient ausnutzen zu können, sind die Werkstücke 2 dabei üblicherweise relativ dicht, also mit geringem Abstand zueinander, in der Kassette 1 angeordnet.

Um die Werkstücke 2 aus der Kassette 1 zu entnehmen, werden regelmäßig verschiedenartig ausgebildete Haltevorrichtungen bzw. Endeffektoren eingesetzt, mittels welchen gezielt eines der Werkstücke 2 greifbar und aus der Kassette 1 entnehmbar ist. Hierzu wird die Haltevorrichtung üblicherweise zwischen die Werkstücke 2, also in die entsprechenden Zwischenräume, eingefahren.

Jedoch ergibt sich insbesondere dann, wenn die Werkstücke 2 eine gebogene Form aufweisen, die Problematik, dass aufgrund des vergleichsweise geringen Abstands zwischen den Werkstücken 2 bei der Entnahme eines der Werkstücke 2 ein Berührungskontakt mit unmittelbar benachbarten Werkstücken 2 nicht immer sicher vermieden werden kann. Eine etwaige Berührung der Werkstücke 2 durch die Haltevorrichtung birgt allerdings die Gefahr einer möglichen Beschädigung der benachbarten Werkstücke 2.

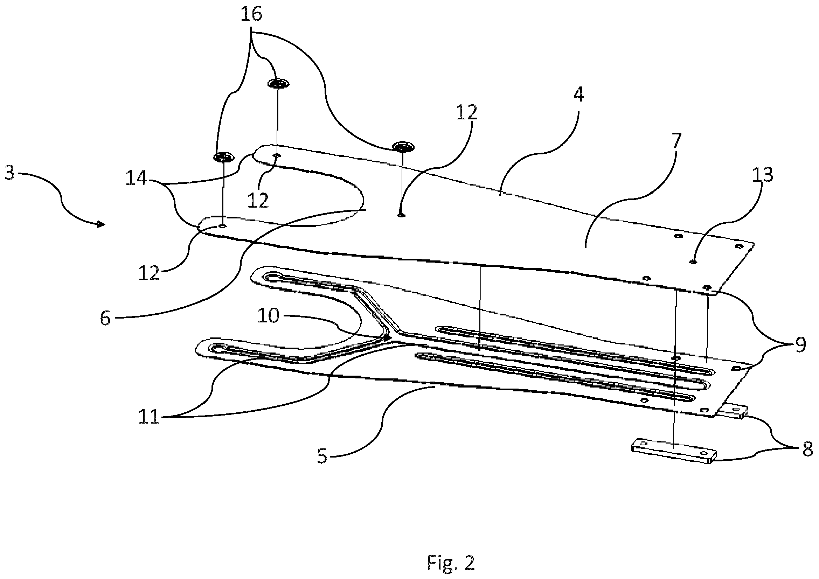

Figur 2 zeigt eine Explosionsdarstellung einer vorteilhaften Haltevorrichtung 3 bzw. eines vorteilhaften Endeffektors, bei welcher die eingangs erwähnte Problematik sicher vermeidbar ist. Aufgrund der im Folgenden beschriebenen Ausbildung der Haltevorrichtung 3 weist diese vorteilhafterweise eine vergleichsweise geringe Dicke bei gleichzeitig hoher Steifigkeit auf, sodass eine sichere Entnahme der Werkstücke 2 aus der Kassette 1 unter Vermeidung einer Berührung benachbarter Werkstücke 2 zuverlässig gewährleistbar ist.

Die Haltevorrichtung 3 bzw. der Endeffektor ist, wie in Figur 2 gut zu erkennen ist, im Wesentlichen gabelförmig sowie zweiteilig ausgebildet, wobei ein erstes Teilelement 4 und ein zweites Teilelement 5 zur Bildung der Haltevorrichtung 3 zusammengesetzt bzw. miteinander verbunden sind.

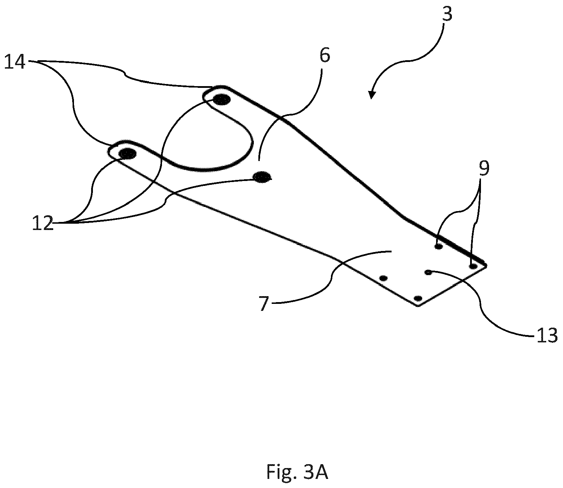

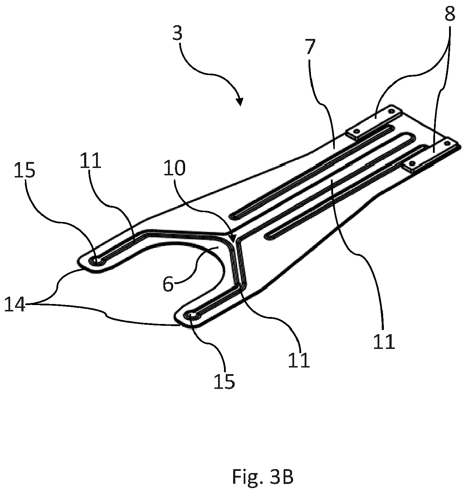

Figur 3A zeigt eine Detailansicht des ersten Teilelements 4, Figur 3B eine Detailansicht des zweiten Teilelements 5.

Die Verbindung der beiden Teilelemente 4, 5 erfolgt bevorzugt stoffschlüssig, vorzugsweise mittels eines 2-Komponenten Klebstoffes oder durch Verschweißen. Alternativ ist jedoch auch eine kraft- und/oder formschlüssige Verbindung denkbar. Vorliegend ist vorgesehen, dass die beiden Teilelemente 4, 5 zumindest hinsichtlich ihres Oberflächenquerschnitts komplementär bzw. deckungsgleich ausgebildet sind.

Die durch die Teilelemente 4, 5 gebildete Haltevorrichtung 3 weist einen mit dem Werkstück 2 kontaktierbaren Halteabschnitt 6 zur Handhabung des Werkstücks 2 und einen Montageabschnitt 7 zur Montage der Haltevorrichtung 3 an einer vorliegend aus Übersichtlichkeitsgründen nicht gezeigten Handhabungseinheit, beispielsweise ein Roboter oder Roboterarm, auf. Vorliegend ist vorgesehen, dass der Halteabschnitt 6 und der Montageabschnitt 7 einstückig miteinander ausgebildet sind. Beide Teilelemente 4, 5 sind dabei als gabelförmiges Blech, also blechförmig, ausgebildet, sodass die Haltevorrichtung 3 insgesamt eine besonders geringe Dicke aufweist und insofern problemlos in die Zwischenräume zwischen den Werkstücken 2 einführbar ist.

Zur Montage der Haltevorrichtung 3 bzw. des Endeffektors an der Handhabungseinheit sind gemäß dem vorliegenden Ausführungsbeispiel weiterhin zumindest zwei Montageelemente 8 vorgesehen, die mittels in den Teilelementen 4, 5 im Bereich des Montageabschnitts 7 ausgebildeten Montageöffnungen 9 an der Haltevorrichtung 3 befestigbar sind. Aus Übersichtlichkeitsgründen sind vorliegend nicht alle Montageöffnung 9 mit einem Bezugszeichen versehen. Mittels der Montageelemente 8 sowie vorliegend aus Übersichtlichkeitsgründen nicht gezeigten Befestigungsmitteln wie Schrauben, Bolzen o.Ä. ist die Haltevorrichtung an der zuvor erwähnten Handhabungseinheit befestigbar.

Zur Handhabung, insbesondere zum Greifen, der Werkstücke 2 ist bei der vorliegenden Haltevorrichtung 3 vorteilhafterweise vorgesehen, dass diese eine Vakuumeinrichtung 10 aufweist. Die Vakuumeinrichtung 10 ist dabei an einen vorliegend aus Übersichtlichkeitsgründen nicht gezeigten Vakuumaktuator, beispielsweise eine Vakuumpumpe, zur Erzeugung des Vakuums bzw. Unterdrucks koppelbar, sodass die Werkstücke 2 schonend und dennoch sicher durch Vakuum ansaugbar bzw. handhabbar sind.

Die Vakuumeinrichtung 10 ist vorliegend zumindest grundsätzlich aus übergangslos miteinander verbundenen Zuleitungen 11 bzw. Vakuumkanälen, mehreren Ansaugöffnungen 12, sowie zumindest einer Vakuumzuführöffnung 13 gebildet. Diese die Vakuumeinrichtung 10 bildenden Elemente sind, wie im Folgenden näher erörtert wird, vorteilhafterweise integral in der Haltevorrichtung 3 bzw. dem Endeffektor ausgebildet, sodass die Vakuumeinrichtung 10 keinen großen Platzbedarf aufweist und die Haltevorrichtung 3 somit vorteilhafterweise mit geringer Dicke ausbildbar ist.

Das erste Teilelement 4 weist dabei die Ansaugöffnungen 12, sowie die Vakuumzuführöffnung 13 auf. Wie insbesondere in Figur 3A gezeigt ist, sind zumindest zwei Ansaugöffnungen endseitig im Bereich des Halteabschnitts 6 angeordnet bzw. ausgebildet. Genauer gesagt ist jeweils eine Ansaugöffnungen 12 am Ende eines Zinkens 14 der Gabelform der Haltevorrichtung 3 angeordnet. Vorliegend ist eine weitere Ansaugöffnung 12 im Wesentlichen mittig im Bereich des Halteabschnitts 6 angeordnet. Die Vakuumzuführöffnung 13 wiederum ist am anderen Ende des ersten Teilelements 4, also am hinteren Ende des Montageabschnitts 7, angeordnet bzw. dort ebenfalls zumindest im Wesentlichen mittig ausgebildet.

Wie in Figur 3B zu erkennen ist, sind die Zuleitungen 11 demgegenüber in dem zweiten Teilelement 5 angeordnet bzw. darin ausgebildet. Vorliegend ist vorteilhafterweise vorgesehen, dass die Zuleitungen 11 durch einen Prägevorgang hergestellt sind, also in das zweite Teilelement 5 eingeprägt und somit sickenartig ausgebildet sind. Die Zuleitungen sind insofern nicht durch einen Materialabtrag, wie es zum Beispiel bei Nuten oder Schlitzen der Fall ist, sondern durch eine mittels Kräften erzeugte Verformung eines Grundkörpers, vorliegend des zweiten Teilelements 5, gebildet. Dadurch ergibt sich eine besonders einfache Herstellung, wobei die Prägung in Art einer Sicke gleichzeitig den Vorteil einer Versteifung und damit einhergehenden mechanischen Stabilität des zweitens Teilelements 5 bzw. der Haltevorrichtung 3 bietet, was demgegenüber bei aus dem Stand der Technik bekannten Lösungen nur durch eine höhere Materialdicke des Endeffektors erreicht wird.

Gleichwohl können auch in beiden Teilelemente 4, 5 durch einen Prägevorgang spiegelbildlich Sicken eingeprägt werden, die eine verbesserte Steifigkeit und einen höheren Zuleitungsquerschnitt bewirken.

Die Zuleitungen 11 sind vorliegend als ein durchgängiger, im Wesentlichen Y-förmiger Vakuumkanal ausgebildet. Der sickenartige Vakuumkanal erstreckt sich dabei vom hinteren Ende des zweiten Teilelements, also vom Montageabschnitt 7, zum vorderen Ende des zweiten Teilelements 5, also dem Halteabschnitt 6, bis hinein in die Zinken 14. Am Ende der Zinken 14 münden die Zuleitungen 11 in Vertiefungen 15, die zur zumindest abschnittsweisen Aufnahme von Saugerelementen 16 dienen, wie an späterer Stelle noch genauer erörtert wird.

Die Zuleitungen 11 bzw. der Vakuumkanal sowie die Ansaugöffnungen 12 und die Vakuumzuführöffnung 13 sind derart in dem jeweiligen Teilelement 4, 5 angeordnet, dass bei bestimmungsgemäßer Montage der Haltevorrichtung 3, also dem deckungsgleichen Zusammenführen der beiden Teilelemente 4, 5, die Öffnungen 12, 13 mit den Zuleitungen 11 fluchten bzw. fluidisch verbunden sind. Dadurch wird bei der zusammengebauten Haltevorrichtung 3 die Vakuumeinrichtung 10 mit einem geschlossenen Vakuumkanal sowie definierten Aus-, und Eintrittspunkten für das Vakuum gebildet. Die Vakuumeinrichtung 10 ist insofern integral in der Haltevorrichtung 3 bzw. dem Endeffektor ausgebildet.

Optional kann der Vakuumkanal auch zur Leitung von flüssigen oder gasförmigen Fluiden wie Luft, Stickstoff oder dergleichen genutzt werden.

Bedingt durch die Ausbildung der Zuleitungen 11 als Sicke ist ein Durchmesser des im montierten Zustand der beiden Teilelemente 4, 5 gebildeten Vakuumkanals größer, als die Dicke der zusammengesetzten Teilelemente 4, 5 im übrigen Bereich. Vorteilhafterweise ist die Haltevorrichtung 3 bzw. der Endeffektor damit besonders dünn bzw. materialsparend und aufgrund der durch die Sicken bereitgestellten Versteifung dennoch ausreichend stabil ausbildbar.

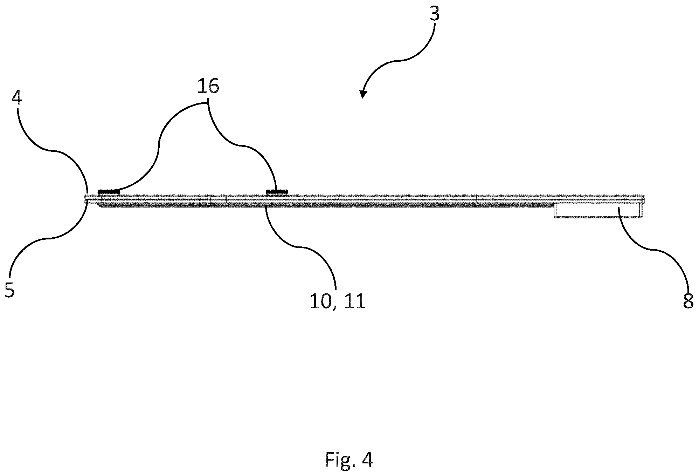

Figur 4 zeigt eine Querschnittsdarstellung durch die vorstehend beschriebene Haltevorrichtung 3 im zusammengebauten Zustand. Wie in Figur 4 deutlich zu erkennen ist, weist die Haltevorrichtung 3 eine vergleichsweise geringe Dicke auf, sodass diese berührungsfrei in die Zwischenräume zwischen den Werkstücken 2 einführbar ist. Gleichzeitig ist durch die sozusagen eingeprägte Vakuumeinrichtung 10 eine effektive Möglichkeit zum sicheren und schonenden Greifen bzw. Ansaugen der Werkstücke 2 bereitgestellt. Gleichzeitig bietet die eingeprägte Vakuumeinrichtung 10 mit den sickenartigen Zuleitungen 11 den Vorteil, dass die Steifigkeit der Haltevorrichtung 3 erhöht wird, sodass diese insgesamt eine geringe Dicke und dennoch eine hohe Steifigkeit aufweist.

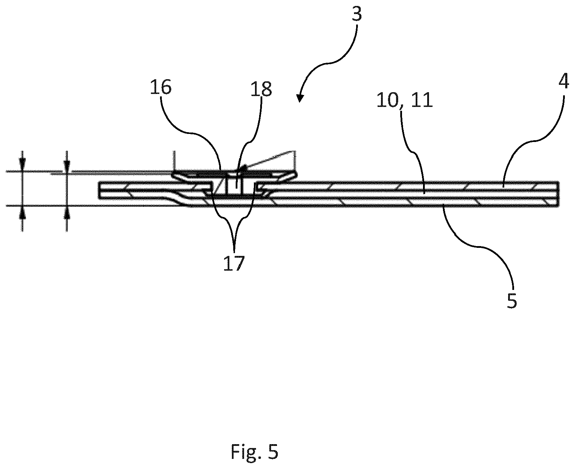

Figur 5 zeigt eine weitere Querschnittsdarstellung durch die Haltevorrichtung 3 bzw. den Endeffektor im Bereich eines der zuvor erwähnten, bei bestimmungsgemäßem Gebrauch in den Ansaugöffnungen 12 angeordneten, Saugerelemente 16. Die Saugerelemente 16 dienen dazu bzw. sind dazu ausgebildet, ein schonendes Greifen bzw. Ansaugen der Werkstücke 2 zu ermöglichen. Zu diesem Zweck sind die Saugerelemente 16 vorliegend aus einem vergleichsweise weichen Material, insbesondere Elastomer oder Kunststoff wie EPDM, gebildet. Weiterhin weisen die Saugerelemente 16 eine auf das zu handhabende Werkstück 2 abgestimmte Oberflächengeometrie auf, sodass stets ein passgenaues Anliegen und damit effektives Ansaugen des Werkstücks 2 ermöglicht ist.

Insofern sind die Saugerelemente 16 austauschbar. Vorteilhafterweise sind Saugerelemente 16 dabei ohne größeren Aufwand und werkzeugfrei, also ohne den Einsatz von speziellem Werkzeug, aus den Ansaugöffnungen 12 entnehmbar bzw. darin einsetzbar. Die Saugerelemente 16 sind vorliegend als Saugpads ausgebildet und weisen, wie in Figur 5 gut zu erkennen ist, einen im Wesentlichen trichterförmigen Querschnitt auf.

Um einen sicheren Halt in der jeweiligen Ansaugöffnung 12 zu ermöglichen, weist jedes Saugerelement 16 eine umlaufende Einklipsnut 17 auf. Bei der Einklipsnut 17 handelt es sich insofern um den Bereich des Saugerelements 16 mit dem geringsten Durchmesser. Wie in Figur 5 gut zu erkennen ist, liegt im eingeklipsten Zustand des Saugerelements 16 ein Teilabschnitt des Saugerelements 16 in einer der zuvor erwähnten Vertiefungen 15 der Zuleitungen 11 ein. Ein weiterer Teilabschnitt des Saugerelements 16 wiederum befindet sich im eingeklipsten Zustand oberhalb der dem Werkstück zugeordneten Oberseite der Haltevorrichtung 3 bzw. des ersten Teilelements 4, sodass die Haltevorrichtung 3 bei bestimmungsgemäßem Gebrauch nur mittels der Saugerelemente 16 mit dem Werkstück 2 in Berührungskontakt steht. Die Ansaugöffnungen 12 sowie die Vertiefungen 15 stellen insofern die mechanische Schnittstelle zur Anordnung der Saugerelemente 16 dar. Somit ist die Vakuumeinrichtung 10 derart ausgebildet, dass die Saugerelemente 16 werkzeugfrei befestigbar und auswechselbar sind.

Wie bereits erwähnt, weist das Saugerelement 16 eine speziell auf das Werkstück 2 abgestimmte Oberflächengeometrie auf, sodass ein sicheres Anliegen an dem Werkstück 2 gewährleistet ist. Die Saugerelemente 16 weisen weiterhin jeweils einen durchgehenden Kanal 18 auf, der fluidisch mit den Zuleitungen 11 bzw. der Vakuumeinrichtung 10 koppelbar ist. Dies ermöglicht das vorgesehene Ansaugen des Werkstücks 2 durch die Haltevorrichtung 3 mittels der Vakuumeinrichtung 10, wobei die Saugerelemente 16 zwischen der Haltevorrichtung 3 bzw. dem Endeffektor und dem Werkstück 2 zwischengeschaltet sind.

### Bezugszeichenliste

- 1: Kassette
- 2: Werkstück
- 3: Haltevorrichtung
- 4: Erstes Teilelement
- 5: Zweites Teilelement
- 6: Halteabschnitt
- 7: Montageabschnitt
- 8: Montageelement
- 9: Montageöffnung
- 10: Vakuumeinrichtung
- 11: Zuleitung
- 12: Ansaugöffnung
- 13: Vakuumzuführöffnung
- 14: Zinken
- 15: Vertiefung
- 16: Saugerelement
- 17: Einklipsnut
- 18: Kanal

## Patentansprüche

1. Haltevorrichtung (3), zum Halten und/oder Transportieren von Werkstücken (2) und/oder Bauteilen, insbesondere der Halbleitertechnik, **dadurch gekennzeichnet, dass** zum Halten und/oder Transportieren der Werkstücke (2) und/oder Bauteile eine Vakuumeinrichtung (10) umfasst ist, wobei die Haltevorrichtung (3) zweiteilig ausgebildet ist, wobei zwei im Wesentlichen parallel zueinander angeordnete, insbesondere blechförmige, Teilelemente (4,5) umfasst sind, wobei zur Bildung der Vakuumeinrichtung (10) Zuleitungen (11) mit endseitigen Ansaugöffnungen (12) vorgesehen sind, sodass ein Vakuum zwischen der Haltevorrichtung (3) und dem Werkstück (2) und/oder Bauteil ausbildbar ist, wobei die Zuleitungen (11) durch einen Prägevorgang in zumindest einem der Teilelemente (5) ausgebildet sind.

2. Haltevorrichtung nach Anspruch 1, **dadurch gekennzeichnet, dass** die Haltevorrichtung (3) zumindest bereichsweise gabelförmig ausgebildet ist und mit dem Werkstück (2) und/oder Bauteil kontaktierbar ist.

3. Haltevorrichtung nach einem der vorhergehenden Ansprüche, **dadurch gekennzeichnet, dass** die Zuleitungen (11), insbesondere aufgrund des Prägevorgangs, sickenartig ausgebildet sind.

4. Haltevorrichtung nach einem der vorhergehenden Ansprüche, **dadurch gekennzeichnet, dass** die Haltevorrichtung (3) einen mit dem Werkstück (2) und/oder dem Bauteil kontaktierbaren Halteabschnitt (6) zur Handhabung des Werkstücks (2) und/oder Bauteil und einen, insbesondere einstückig mit dem Halteabschnitt (6) ausgebildeten, Montageabschnitt (7) zur Montage der Haltevorrichtung (3) an einer Handhabungseinheit, insbesondere Roboter oder Roboterarm, aufweist.

5. Haltevorrichtung nach einem der vorhergehenden Ansprüche, **dadurch gekennzeichnet, dass** die Teilelemente (4,5) im Wesentlichen deckungsgleich und/oder komplementär ausgebildet sind, wobei die Teilelemente (4,5) zur Bildung der Haltevorrichtung (3) stoffschlüssig miteinander verbunden sind.

6. Haltevorrichtung nach einem der vorhergehenden Ansprüche, **dadurch gekennzeichnet, dass** in den Ansaugöffnungen (12) Saugerelemente (16) eingebracht sind.

7. Haltevorrichtung nach Anspruch 6, **dadurch gekennzeichnet, dass** die Saugerelemente (16) als werkzeugfrei in den Ansaugöffnungen (12) anordenbare, insbesondere in die Ansaugöffnungen (12) einklipsbare, Saugpads (16) ausgebildet sind, wobei die Saugpads (16) eine umlaufende Einklipsnut (17) aufweisen.

8. Verfahren zum Halten und/oder Transportieren von Werkstücken (2) und/oder Bauteilen, insbesondere der Halbleitertechnik, umfassend insbesondere eine Haltevorrichtung (3) nach einem der Ansprüche 1 bis 7.

9. Verfahren zur Herstellung einer Haltevorrichtung (3) nach einem der Ansprüche 1 bis 7, **dadurch gekennzeichnet, dass** die Zuleitungen in Form einer Sicke durch einen Prägevorgang in zumindest einem der Teilelemente (4, 5) eingeprägt werden.
